# EUROPÄISCHE PATENTANMELDUNG

(11) **EP 1 331 695 A2**
(43) Veröffentlichungstag der Anmeldung: **30.07.2003**
(21) Anmeldenummer: 02025306.8
(22) Anmeldetag: 13.11.2002
(51) Int. Cl.: H01R 12/24

(54) **Elektronische Baugruppe**

(30) Priorität: 23.01.2002 DE 10202379
(71) Anmelder: Conti Temic microelectronic GmbH, 90411 Nürnberg (DE)
(72) Erfinder: Jahn, Michael, 02977 Hoyerswerda (DE)

(57) **Zusammenfassung**

2.1 Vorgeschlagen wird eine einfache und kostengünstige Anordnung der elektronischen Baugruppe, die ein als Einpresskontakt ausgebildetes Kontaktelement mit mindestens einem in eine Leiterplatte eingesetzten Einpresspin zur Ausbildung einer Kontaktstelle auf der Leiterplatte und mindestens eine Kontaktzunge zur Ausbildung einer Kontaktstelle auf der Schaltfolie einer Leiterfolie aufweist.
2.2 Hierzu ist der Einpresskontakt hakenförmig ausgebildet, wobei der Einpresspin den geraden Teilbereich und die Kontaktzunge den gebogenen Teilbereich des Einpresskontakts bildet. Die Leiterfolie ist zwischen der Kontaktzone der Kontaktzunge und einem Gehäusekörper angeordnet.
2.3 Elektronische Baugruppe als Steuergerät im Kfz-Bereich.

## Beschreibung

Die Erfindung betrifft eine elektronische Baugruppe nach dem Oberbegriff des Patentanspruchs 1 wie sie aus der nicht vorveröffentlichten DE 101 57 113 bekannt ist.
In vielen Bereichen werden elektronische Baugruppen für unterschiedliche Aufgaben und Anwendungen eingesetzt; insbesondere sind (bsp. im Kraftfahrzeugbereich zur Steuerung und/oder Regelung fahrspezifischer Abläufe oder von Komfortfunktionen) als elektronische Baugruppen Steuergeräte mit Sensoren zur Erfassung der Meßwerte physikalischer Größen, wie beispielsweise der Temperatur, der Drehzahl oder des Drucks und/oder mit Aktoren zur Betätigung von Stellgliedern gebräuchlich.
Als Trägerkörper für die Bauteile der elektronischen Baugruppe ist üblicherweise eine eine Leiterbahnstruktur aufweisende Leiterplatte vorgesehen; daneben kann als weiterer Trägerkörper für Bauteile der elektronischen Baugruppe und/oder als Verdrahtungsträger für die elektrische Kontaktierung (bsp. zur externen Kontaktierung der elektronischen Baugruppe) eine Leiterfolie mit einer Leiterbahnstruktur vorgesehen werden. Hierbei muß eine elektrisch leitende Verbindung zwischen (mindestens einer Kontaktstelle) der Leiterbahnstruktur der Leiterplatte und (mindestens einer Kontaktstelle) der Leiterbahnstruktur der Leiterfolie vorgesehen werden; dies wird in der Regel mittels eines von der Leiterbahnstruktur der Leiterplatte ausgehenden Steckverbinders realisiert, der durch Löten oder Crimpen und damit dauerhaft fixiert mit der Leiterbahnstruktur der Leiterfolie verbunden wird. Wegen der nicht wieder lösbaren Verbindung ist ein derartiger Steckverbinder jedoch für viele Anwendungszwecke unvorteilhaft oder nicht geeignet.

Bei der gattungsgemäßen elektronischen Baugruppe aus der DE 101 57 113 wird die elektrisch leitende Verbindung zwischen der Leiterplatte und der zwischen zwei Isolationsfolien angeordneten Schaltfolie der Leiterfolie durch ein als Einpresskontakt ausgebildetes, vorzugsweise symmetrisch aufgebautes Kontaktelement realisiert, das mindestens einen Einpresspin zur Kontaktierung der Leiterbahnstruktur der Leiterplatte und mindestens eine Kontaktzunge zur Kontaktierung der Leiterbahnstruktur der Schaltfolie aufweist. Die zur Kontaktierung der Leiterbahnstruktur der Leiterplatte vorgesehenen Einpresspins sind seitlich am Kontaktelement angeformt und können für den Einpressvorgang im gewünschten Winkel gebogen werden; die zur Kontaktierung der Leiterbahnstruktur der Schaltfolie vorgesehene, mittig im Kontaktelement angeordnete Kontaktzunge weist an ihrer Unterseite im Endbereich mindestens eine Schneide zum Freilegen der zu kontaktierenden Leiterbahnstruktur auf der Schaltfolie und weiterhin mindestens eine Kontaktzone zur Realisierung einer gasdichten Kontaktstelle auf der Leiterbahnstruktur der Schaltfolie auf. Weiterhin ist seitlich angrenzend auf beiden Seiten längs zu den Kontaktzonen mindestens ein Schleifer zur Gewährleistung eines zuverlässigen Einpressvorgangs angeordnet.

Der Erfindung liegt die Aufgabe zugrunde, eine elektronische Baugruppe nach dem Oberbegriff des Patentanspruchs 1 mit einem einfachen Aufbau, einer einfachen Fertigung, geringen Kosten, einer hohen Zuverlässigkeit und vorteilhaften Eigenschaften bezüglich der elektrischen Verbindung anzugeben.
Diese Aufgabe wird nach der Erfindung durch die Merkmale im Kennzeichen des Patentanspruchs 1 gelöst.
Vorteilhafte Ausgestaltungen der Erfindung sind Bestandteil der weiteren Patentansprüche.

Zur elektrisch leitenden Verbindung der Leiterplatte der elektronischen Baugruppe mit der Leiterfolie der elektronischen Baugruppe und damit zur elektrischen Kontaktierung der Leiterbahnstruktur der Leiterplatte einerseits und der Leiterbahnstruktur der Schaltfolie der Leiterfolie andererseits ist mindestens ein als hakenförmiger Einpresskontakt (als Klemmfeder oder Kontaktfeder) realisiertes Kontaktelement vorgesehen, bei dem der zur Kontaktierung der Leiterbahnstruktur der Leiterplatte vorgesehene Einpresspin den geraden Teilbereich des hakenförmigen Einpresskontakts und die zur Kontaktierung der Leiterbahnstruktur der Leiterfolie vorgesehene Kontaktzunge als Federelement den gebogenen Teilbereich des hakenförmigen Einpresskontakts bildet. Hierbei kann die elektronische Baugruppe eine beliebige Anzahl derartiger Einpresskontakte aufweisen, insbesondere mehrere hintereinander und/oder nebeneinander angeordnete Einpresskontakte. Der zur Kontaktierung der Leiterbahnstruktur der Leiterplatte und damit zur Ausbildung der Kontaktstelle auf der Leiterbahnstruktur der Leiterplatte vorgesehene Einpresspin des Einpresskontakts wird in einem Einpressvorgang an einer bestimmten Kontaktierungsstelle in die Leiterplatte eingepresst; bsp. wird der Einpresskontakt in eine in der Leiterplatte vorgesehene Durchkontaktierung als Kontaktierungsstelle eingepresst. Die zur Kontaktierung der Leiterbahnstruktur der Leiterfolie und damit zur Ausbildung der Kontaktstelle auf der Leiterbahnstruktur der Leiterfolie vorgesehene Kontaktzunge wird vor dem Einpressvorgang in einem Biegevorgang in die gewünschte gebogene Form gebracht, insbesondere wird die Kontaktzunge halbkreisförmig gebogen; die Kontaktzunge weist an ihrer Außenseite, vorzugsweise in der Mitte des gebogenen Teilbereichs und damit in der Verlängerung des geraden Teilbereichs eine vorzugsweise rundliche, bsp. halbkugelförmige Kontaktzone zur Realisierung einer gasdichten Kontaktstelle auf der Leiterbahnstruktur der Leiterfolie auf.
Das Kontaktelement ist vorzugsweise als Stanzbiegeteil ausgebildet und besteht aus einem elektrisch leitfähigen Material mit den erforderlichen Federeigenschaften für den Einpressvorgang und den Biegevorgang und damit für die elektrische Kontaktierung der Leiterbahnstruktur der Leiterplatte sowie für die elektrische Kontaktierung der Leiterbahnstruktur der Schaltfolie der Leiterfolie. Bsp. besteht das Kontaktelement aus einer metallischen Legierung, insbesondere aus einem kupferhaltigen Kontaktwerkstoff, bsp. aus einer Kupfer-Zinn-Bronze (CuSn) oder aus Kupfer-Nickel-Silizium (CuNiSi).

Der im Einpressvorgang in die Leiterplatte, insbesondere in Bohrungen in der Leiterplatte, bsp. in als Durchkontaktierungen durch die Leiterplatte ausgebildete Bohrungen, eingepresste Einpresspin des Einpresskontakts wird zur Ausbildung von Kontaktstellen mit der Leiterbahnstruktur der Leiterplatte kontaktiert; bsp. werden die Kontaktstellen auf der Oberseite der Leiterplatte und/oder auf der Unterseite der Leiterplatte und/oder in der Leiterplatte ausgebildet (insbesondere bei einer mehrere Leiterbahnebenen aufweisenden Mehrschicht-Leiterplatte), bsp. im Bereich von Durchkontaktierungen durch die Leiterplatte. Die vor dem Einpressvorgang im Biegevorgang in die gewünschte Form gebogene Kontaktzunge des Einpresskontakts steht nach dem Einpressen des Einpresspins als Federelement auf der Oberseite der Leiterplatte über. Die Leiterplatte wird nun in einen zumindest einseitig offenen, bsp. aus Kunststoff bestehenden Gehäusekörper eingebracht, der als Klemme bzw. Klammer die Leiterplatte mechanisch fixiert und die Kontaktzunge des Einpresskontakts etwas zusammendrückt (Vorspannung der Kontaktzunge des Einpresskontakts). Für die Kontaktierung muss die Schaltfolie der Leiterfolie zumindest an den vorgesehenen Kontaktierungsstellen zugänglich sein; bei einer flexiblen gedruckten Leiterplatte als Leiterfolie ist die auf dem als Isolationsschicht dienenden Trägerkörper angeordnete Leiterbahnstruktur der Schaltfolie bereits vollständig zugänglich, bei einer Leiterfolie mit einer zwischen zwei Isolationsfolien als Isolationsschicht angeordneten Schaltfolie wird hierzu eine der Isolationsfolien zumindest partiell an den vorgesehenen Kontaktierungsstellen entfernt und damit die Schaltfolie partiell auf einer Oberflächenseite an den vorgesehenen Kontaktierungsstellen freigelegt. Die Leiterfolie wird nun derart in den Gehäusekörper eingelegt, vorzugsweise unter Zuhilfenahme von auf dem Gehäusekörper ausgebildeten Einführhilfen (Positionierhilfen), dass die Schaltfolie der Leiterfolie auf der Oberseite der Kontaktzungen positioniert wird, d.h. auf den Kontaktzonen der Kontaktzungen zu liegen kommt, und die Isolationsschicht (d.h. bsp. entweder der Trägerkörper für die Schaltfolie oder die vollständig erhaltene Isolationsfolie) auf der Innenseite des Gehäusekörpers anliegt. Die bsp. als Einführnuten im Gehäusekörper ausgebildeten Einführhilfen gewährleisten, dass die Schaltfolie der Leiterfolie wie vorgesehen bezüglich der Kontaktzungen positioniert wird, wodurch die Kontaktzonen der Kontaktzungen an den gewünschten Kontaktierungsstellen Kontaktstellen auf der Leiterbahnstruktur der Schaltfolie ausbilden. Aufgrund der Federkraft der Kontaktzunge und der Materialverformung an der Oberfläche der Schaltfolie der Leiterfolie (d.h. an der Grenzfläche zwischen der Oberfläche der Kontaktzone der Kontaktzunge und der Oberfläche der Schaltfolie der Leiterfolie) wird eine gasdichte Kontaktierung der Schaltfolie und damit eine vor dem Eindringen von Feuchtigkeit geschützte Kontaktstelle auf der Leiterbahnstruktur der Schaltfolie realisiert. Bsp. besteht die Leiterbahnstruktur der Schaltfolie aus Kupfer; die Kontaktzone der Kontaktzunge besteht vorzugsweise aus einem Metall, zumindest aber weist sie eine metallische Oberfläche auf, bsp. eine verzinnte Oberfläche.
Auf der Leiterfolie können Anschlusskontakte für die externe Kontaktierung der elektronischen Baugruppe ausgebildet werden, bsp. können die Anschlusskontakte durch Crimpen oder Schweißen oder Löten auf die Schaltfolie der Leiterfolie aufgebracht werden; insbesondere können mehrere Anschlusskontakte als Steckeranschluss zusammengefasst werden und bsp. in einem gemeinsamen Steckergehäuse integriert werden. An die Anschlusskontakte und insbesondere an einen Steckeranschluss können geeignete Anschlusskomponenten angeschlossen werden, insbesondere Anschlussleitungen oder Anschlussstecker.
Die Bauteile der Schaltungsanordnung der elektronischen Baugruppe werden auf die Leiterplatte und/oder auf die Leiterfolie aufgebracht und mit der Leiterbahnstruktur der Leiterplatte und/oder der Leiterbahnstruktur der Leiterfolie auf geeignete Weise leitend verbunden. Nach dem Einbringen der Schaltfolie und der Ausbildung der Kontaktstellen auf der Leiterbahnstruktur der Schaltfolie können die offenen Seiten des Gehäusekörpers optional verschlossen werden, wodurch ein allseitig geschlossenes Gehäuse für den Einsatz der elektronischen Baugruppe bereitgestellt wird.

Die elektronische Baugruppe vereinigt mehrere Vorteile in sich:
- Das Kontaktelement gewährleistet einen guten elektrischen Kontakt sowohl zur Leiterbahnstruktur der Leiterplatte als auch zur Leiterbahnstruktur der Schaltfolie der Leiterfolie, insbesondere auch beim Einsatz der elektronischen Baugruppe unter schwierigen äußeren Bedingungen.
- Das aus wenig Einzelteilen einfach aufgebaute Kontaktelement kann in einem kostengünstigen Massenprozess hergestellt werden, insbesondere als Stanzbiegeteil.
- Aufgrund der vorgebbaren und variierbaren Ausgestaltung des Kontaktelements kann eine flexible Kontaktierung realisiert werden, wodurch auch Änderungen bei der elektronischen Baugruppe (insbesondere im Aufbau der elektronischen Baugruppe) schnell und kostengünstig umgesetzt werden können.
- Je nach Anforderung an die Kontaktierung (bsp. in Abhängigkeit der Anzahl der zu kontaktierenden Leiterbahnen der Leiterbahnstruktur) kann ein Kontaktelement als Einzelkontakt zur Ausbildung von jeweils einer Kontaktstelle auf der Leiterbahnstruktur der Leiterplatte und der Leiterbahnstruktur der Leiterfolie eingesetzt werden oder es können mehrere Kontaktelemente als Mehrfachkontakt zur Ausbildung von mehreren Kontaktstellen auf der Leiterbahnstruktur der Leiterplatte und der Leiterbahnstruktur der Leiterfolie eingesetzt werden.
- Eine fehlerhafte Kontaktstelle kann durch Ersatz des entsprechenden Kontaktelements auf einfache Weise beseitigt werden; insbesondere kann dies durch Auspressen des entsprechenden Kontaktelements und Einpressen eines neuen Kontaktelements erfolgen.

Im Zusammenhang mit der Zeichnung (Figuren 1 bis 5) soll die elektronische Baugruppe anhand eines Ausführungsbeispiels erläutert werden.
Hierbei zeigen:
- Figur: 1 eine Ansicht des Einpresskontakts als Kontaktelement im Ausgangszustand vor dem Biegevorgang und damit vor dem Einpressvorgang,
- Figur 2: eine Ansicht des Einpresskontakts als Kontaktelement nach dem Biegevorgang und vor dem Einpressvorgang in verschiedenen Perspektiven (Figur 2.1 bis Figur 2.4),
- Figur 3: in einem Ausschnitt eine Schnittzeichnung der elektronischen Baugruppe mit dem Verbund aus Leiterplatte und Leiterfolie nach der elektrischen Verbindung von Kontaktelement und Leiterfolie,
- Figur 4: eine Detailansicht der bei der elektrischen Verbindung von Kontaktelement und Leiterfolie gebildeten Kontaktstelle,
- Figur 5: in einem Ausschnitt eine perspektivische Ansicht der elektronischen Baugruppe mit dem Verbund aus Leiterplatte und Leiterfolie.

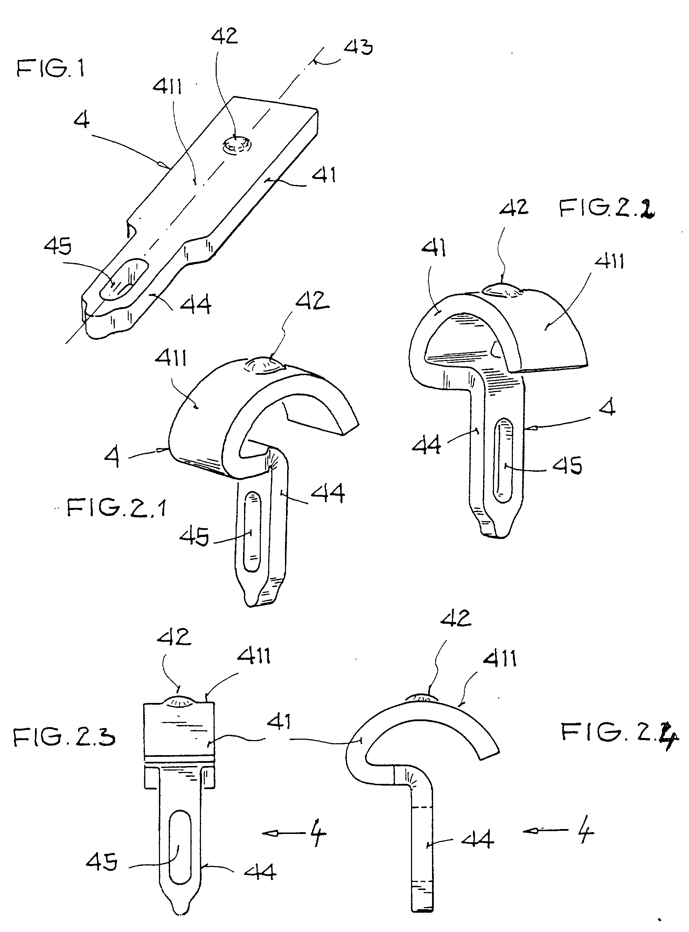

In der Figur 1 ist ein bsp. aus Kupfer-Nickel-Silizium (CuNiSi) bestehender, als Stanzbiegeteil gefertigter Einpresskontakt als Kontaktelement 4 im Ausgangszustand (im abgewickelten Zustand) nach dem Ausstanzen und vor dem Biegevorgang dargestellt. Der symmetrisch bezüglich der Längsachse 43 ausgebildete Einpresskontakt 4 weist eine Kontaktzunge 41 auf, auf deren Oberseite 411 eine bsp. geprägte Kontaktzone 42 vorgesehen ist; die Kontaktzunge 41 wird in einem Biegevorgang vor dem Einpressen des Einpresskontakts 4 in die gewünschte Form gebogen. Angrenzend an die Kontaktzunge 41 ist ein Einpresspin 44 angeformt; um eine Flexibilität des Einpresspins 44 insbesondere beim Einpressvorgang zu gewährleisten, kann im Einpresspin 44 mindestens eine Aussparung 45 vorgesehen werden. Bsp. weist der Einpresskontakt 4 vor dem Biegevorgang eine Gesamtlänge von 6.5 mm auf, wobei die Länge des Einpresspins 44 bsp. 2.5 mm beträgt; die Breite der Kontaktzunge 41 beträgt bsp. 1.2 mm, die Breite des Einpresspins 44 beträgt bsp. 0.7 mm.
In der Figur 2 (Figur 2.1 bis Figur 2.4) ist der Einpresskontakt 4 nach dem Biegevorgang (im abgewinkelten Zustand) vor dem Einpressvorgang in verschiedenen Perspektiven dargestellt. Beim Biegevorgang wird die Kontaktzunge 41 näherungsweise halbkreisförmig umgebogen und bildet den gebogenen Teilbereich des Einpresskontakts 4, wobei die auf der Oberseite 411 der Kontaktzunge 41 angeordnete Kontaktzone 42 sich mittig im gebogenen Teilbereich der Kontaktzunge 41 befindet; der Einpresspin 44 wird dagegen nicht umgebogen und bildet den geraden Teilbereich des Einpresskontakts 4, so dass der Einpresskontakt 4 nach dem Biegevorgang eine hakenförmige Gestalt besitzt. Bsp. weist der Einpresskontakt 4 nach dem Biegevorgang eine Gesamthöhe von 3.6 mm auf; die Gesamtlänge des Einpresskontakts 4 nach dem Biegevorgang 41 beträgt bsp. 2.6 mm, die Länge des Einpresspins 44 beträgt bsp. 0.35 mm.

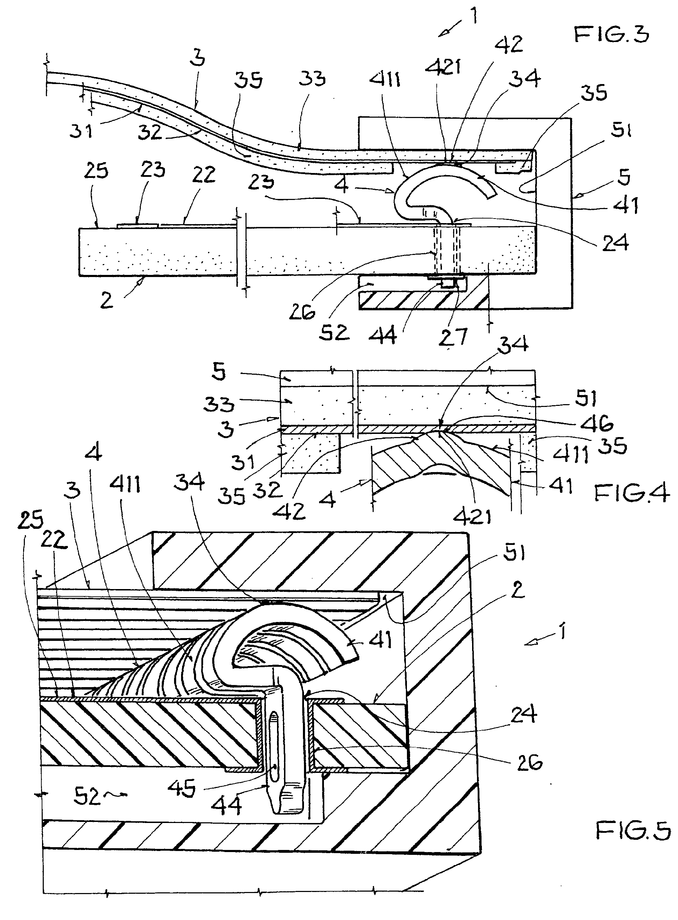

In der Figur 3 ist eine Schnittzeichnung des Verbunds aus Leiterplatte 2 und Leiterfolie 3 nach dem Einpressvorgang des Einpresskontakts 4 und dem Einlegen der Leiterfolie 3 und damit nach der elektrischen Kontaktierung der Leiterplatte 2 und der Leiterfolie 3 durch den Einpresskontakt 4 dargestellt.
Die Leiterplatte 2 weist auf der Oberseite 25 eine Leiterbahnstruktur 22 mit Leiterbahnen (Verbindungsleitungen) 23 auf; weiterhin sind in der Leiterplatte 2 Durchkontaktierungen 26 als Kontaktierungsstellen zur Ausbildung von Kontaktstellen 24 vorgesehen. Die Leiterfolie 3 besteht aus einer ersten Isolationsfolie als Isolationsschicht 33, einer zweiten Isolationsfolie als Isolationsschicht 35 und einer zwischen der ersten Isolationsfolie 33 und der zweiten Isolationsfolie 35 angeordneten, eine Leiterbahnstruktur 32 mit Leiterbahnen aus Kupfer tragenden Schaltfolie 31. Weiterhin ist ein Gehäusekörper 5 vorgesehen, der die Leiterplatte 2 und damit auch die auf der Leiterplatte 2 aufgebrachten Bauteile sowie die Leiterfolie 3 umschließt.
Durch den Einpresskontakt 4 wird an einer bestimmten Kontaktstelle 34 die Schaltfolie 31 der Leiterfolie 3 und an einer bestimmten Kontaktstelle 24 die Leiterplatte 2 elektrisch kontaktiert, insbesondere zur elektrisch leitenden Verbindung der Leiterbahnstruktur 32 der Schaltfolie 31 der Leiterfolie 3 mit der Leiterbahnstruktur 22 der Leiterplatte 2. Zur elektrischen Kontaktierung der Leiterplatte 2 wird der (gerade) Einpresspin 44 des Einpresskontakts 4 in eine in der Leiterplatte 2 vorgesehene Durchkontaktierung 26 eingepresst und hierdurch im Bereich dieser Durchkontaktierung 26 die Kontaktstelle 24 mit der Leiterbahnstruktur 22 der Leiterplatte 2 ausgebildet (entweder auf der Oberseite 25 der Leiterplatte 2 oder auf der Unterseite 27 der Leiterplatte 2 oder in der Leiterplatte 2). Die Leiterplatte 2 wird anschließend in den zumindest einseitig offenen, bsp. U-förmig ausgebildeten und damit als Klammer wirkenden Gehäusekörper 5 (Gehäuserahmen) eingebracht, dessen Abmessungen so gewählt sind, dass der Einpresspin 44 beim Einbringen in den Gehäusekörper 5 etwas zusammengedrückt wird; bsp. weist der bsp. aus Kunststoff bestehende.Gehäusekörper 5 eine Höhe von 5.3 mm auf, so dass die Oberseite 411 der Kontaktzunge 41 und damit die Oberseite 421 der Kontaktzone 42 auf der Innenseite 51 des Gehäusekörpers 5 bündig aufliegt. Zur elektrischen Kontaktierung der Leiterfolie 3 wird die zweite Isolationsfolie 35 der Leiterfolie 3 partiell entfernt und somit die Leiterbahnstruktur 32 der Schaltfolie 31 für die Ausbildung der Kontaktstelle 34 in bestimmten Bereichen einseitig freigelegt. Die Leiterfolie 3 wird nun so zwischen die Innenseite 51 des Gehäusekörpers 5 und die Oberseite 411 der Kontaktzunge 41 eingelegt, dass die erste Isolationsfolie 33 der Innenseite 51 des Gehäusekörpers 5 zugewandt und die Oberseite 421 der bsp. halbkugelförmig ausgebildeten Kontaktzone 42 mit der Schaltfolie 31 der Leiterfolie 3 in Verbindung gebracht ist; hierdurch wird in dem Bereich, in dem die zweite Isolationsfolie 35 der Leiterfolie 3 entfernt wurde, die Kontaktstelie 34 mit der Leiterbahnstruktur 32 der Schaltfolie 31 ausgebildet. Bsp. sind Einführhilfen 52 zur genauen Positionierung der Leiterfolie 3 und damit der Schaltfolie 31 der Leiterfolie 3 bezüglich der Kontaktzonen 42 vorgesehen, d.h. zur genauen Positionierung der gewünschten Kontaktstelle 34; diese Einführhilfen 52 sind bsp. als auf der Innenseite 51 des Gehäusekörpers 5 ausgebildete Einführnuten realisiert. Aufgrund der Federkraft der Kontaktzungen 41 und der Form der Kontaktzonen 42 (insbesondere durch Ausbildung der Kontaktzonen 42 mit einem bestimmten Krümmungsradius) wird eine Beschädigung der Schaltfolie 31 der Leiterfolie 3 und damit ein Eindringen der Kontaktzone 42 in die auf der Innenseite 51 des Gehäusekörpers 5 anliegende erste Isolationsfolie 33 der Leiterfolie 3 verhindert.

In der Figur 4 ist eine Detailansicht der bei der elektrischen Verbindung des Einpresskontakts 4 mit der Leiterfolie 3 gebildeten Kontaktstelle 34 dargestellt. Aufgrund der Federkraft des Einpresskontakts 4 wird die Grenzfläche 46 zwischen dem Einpresskontakt 4 und der Leiterfolie 3 verformt, d.h. die Grenzfläche 46 zwischen der Kontaktzone 42 der Kontaktzunge 41 des Einpresskontakts 4 und der Schaltfolie 31 der Leiterfolie 3, wodurch eine Materialverbindung (Verschmelzung) des Materials der Kontaktzone 42 des Einpresskontakts 4 (bsp. Kupfer-Nickel-Silizium CuNiSi) mit dem Kupfer als Material der Leiterbahnstruktur 32 der Schaltfolie 31 der Leiterfolie 3 stattfindet. Hierdurch wird eine vor dem Eindringen von Feuchtigkeit geschützte und damit zuverlässige gasdichte Kontaktstelle 34 realisiert.

In der Figur 5 ist in einer perspektivische Ansicht ein Ausschnitt des Verbunds aus Leiterplatte 2 und Leiterfolie 3 eines Türsteuergeräts als elektronischer Baugruppe 1 dargestellt; das Türsteuergerät 1 ist bsp. in der Seitentüre eines Kraftfahrzeugs integriert und dient bsp. u.a. für die Ansteuerung der Fensterheber, Außenspiegel und Airbags des Kraftfahrzeugs. Die Leiterplatte 2 besteht bsp. aus glasfasergefülltem Epoxydharz (FR4) und besitzt bsp. die Abmessungen von 60 mm x 70 mm x 1.6 mm. Auf der Oberseite 25 der Leiterplatte 2 sind elektronische Bauteile angeordnet und auf geeignete Weise mit der dort aufgebrachten Leiterbahnstruktur 22 verbunden. Die als Trägerkörper bzw. Verdrahtungsträger dienende Leiterfolie 3 besitzt bsp. die Abmessungen von 0.6 mm x 40 mm x 500 mm. Durch mehrere Einpresskontakte 4 werden auf der Schaltfolie 31 der Leiterfolie 3 mehrere Kontaktstellen 34 und auf der Leiterbahnstruktur 22 der Leiterplatte 2 mehrere Kontaktstellen 24 gebildet und damit auch elektrisch leitende Verbindungen dieser Kontaktstellen 24, 34 realisiert. Durch die Leiterfolie 3 wird eine externe Anschlussmöglichkeit für das Türsteuergerät 1 bereitgestellt, insbesondere durch Ausbildung von Anschlusskontakten auf der Leiterfolie 3, bsp. durch Crimpen von Anschlusskontakten auf die Schaltfolie 31 der Leiterfolie 3. Zur externen Kontaktierung des Türsteuergeräts 1 können bsp. mehrere Anschlusskontakte zur Bildung eines Steckeranschlusses zusammengefasst werden, an dem bsp. ein Anschlussstecker zur Verbindung des Türsteuergeräts 1 mit weiteren Bauteilen und/oder elektronischen Baugruppen und/oder mit Spannungsquellen zur Spannungsversorgung angeschlossen werden kann. Bsp. wird das Türsteuergerät 1 über einen Anschlussstecker mit Bedienelementen des Kraftfahrzeugs verbunden.

## Patentansprüche

1. Elektronische Baugruppe (1)
mit einer Leiterplatte (2),
mit einer eine Schaltfolie (31) aufweisenden Leiterfolie (3),
und mit einem Kontaktelement (4), das als Einpresskontakt einen in die Leiterplatte (2) eingepressten Einpresspin (44) zur Ausbildung einer Kontaktstelle (24) auf der Leiterplatte (2) und eine Kontaktzunge (41) mit einer Kontaktzone (42) zur Ausbildung einer Kontaktstelle (34) auf der Schaltfolie (31) der Leiterfolie (3) aufweist,
**dadurch gekennzeichnet,**
**dass** der Einpresspin (44) als gerader Teilbereich und die Kontaktzunge (41) als gebogener Teilbereich eines hakenförmigen Kontaktelements (4) ausgebildet ist, und dass die Leiterfolie (3) zwischen der Kontaktzone (42) der Kontaktzunge (41) und einem Gehäusekörper (5) angeordnet ist.

2. Elektronische Baugruppe nach Anspruch 1, **dadurch gekennzeichnet, dass** die Leiterfolie (3) eine Isolationsschicht (33) aufweist, die auf der Innenseite (51) des Gehäusekörpers (5) anliegt.

3. Elektronische Baugruppe nach Anspruch 1 oder 2, **dadurch gekennzeichnet, dass** die Kontaktzone (42) eine rundliche Form aufweist.

4. Elektronische Baugruppe nach einem der Ansprüche 1 bis 3, **dadurch gekennzeichnet, dass** die Kontaktzone (42) mittig auf der Außenseite (411) des gebogenen Teilbereichs des Kontaktelements (4) angeordnet ist.

5. Elektronische Baugruppe nach einem der Ansprüche 1 bis 4, **dadurch gekennzeichnet, dass** das Kontaktelement (4) als Stanzbiegeteil ausgebildet ist.

6. Elektronische Baugruppe nach einem der Ansprüche 1 bis 5, **dadurch gekennzeichnet, dass** auf der Leiterfolie (3) des Kontaktelements (4) Anschlusskontakte zur externen Kontaktierung der elektronischen Baugruppe (1) ausgebildet sind.

7. Elektronische Baugruppe nach Anspruch 6, **dadurch gekennzeichnet, daß** mehrere Anschlusskontakte zu einem Steckeranschluss zusammengefasst sind.
